# FASCICULE DE BREVET EUROPEEN

(11) **EP 3 153 606 B1**
(45) Date de publication et mention de la délivrance du brevet: **09.10.2019**
(21) Numéro de dépôt: 15306602.2
(22) Date de dépôt: 09.10.2015
(51) Int. Cl.: C30B 7/08, C30B 29/54, B01D 9/00, C02F 1/22, C02F 1/00, C02F 1/52

(54) **PROCEDE POUR CRISTALLISER DES CLATHRATES HYDRATES, ET PROCEDE DE PURIFICATION D'UN LIQUIDE AQUEUX UTILISANT LES CLATHRATES HYDRATES AINSI CRISTALLISES**
VERFAHREN ZUM KRISTALLISIEREN VON HYDRAT-CLATHRATEN, UND VERFAHREN ZUR REINIGUNG EINER WÄSSRIGEN FLÜSSIGKEIT ANHAND DER SO KRISTALLISIERTEN HYDRAT-CLATHRATE
METHOD FOR CRYSTALLISING CLATHRATE HYDRATES, AND METHOD FOR PURIFYING AN AQUEOUS LIQUID USING THE CLATHRATE HYDRATES THUS CRYSTALLISED

(43) Date de publication de la demande: 12.04.2017
(73) Titulaire: BGH, 64170 Lacq (FR)
(72) Inventeur: MOTTET, Bruno, 56520 GUIDEL (FR)
(74) Mandataire: Brevalex

(56) Documents cités:
- US-A1- 2003 209 492
- US-A1- 2007 207 082
- DAISUKE KATSUKI ET AL: "Formation, growth and ageing of clathrate hydrate crystals in a porous medium", PHILOSOPHICAL MAGAZINE, vol. 86, no. 12, 21 avril 2006 (2006-04-21), pages 1753-1761, XP055259506, GB ISSN: 1478-6435, DOI: 10.1080/14786430500509062

## Description

### DOMAINE TECHNIQUE

L'invention a trait à un procédé pour cristalliser des clathrates hydrates.

Plus exactement, l'invention a trait à un procédé pour cristalliser des clathrates hydrates d'une molécule hôte dans un liquide aqueux, c'est-à-dire un liquide comprenant de l'eau, telle qu'une solution aqueuse.

L'invention a trait en outre à un procédé tel qu'un procédé de purification d'un liquide aqueux utilisant les clathrates hydrates ainsi cristallisés.

Plus exactement, l'invention a trait en outre à un procédé de purification d'un liquide aqueux, dans lequel on cristallise des clathrates hydrates d'une molécule hôte dans le liquide aqueux par le procédé selon l'invention; on sépare les clathrates hydrates du liquide ; et enfin on dissocie les clathrates hydrates séparés pour obtenir de l'eau pure et la molécule hôte.

Par purification de l'eau, on entend généralement toute opération consistant à traiter une eau contenant des impuretés à une teneur initiale de façon à ce qu'à l'issue de cette opération, la teneur finale en impuretés soit inférieure à la teneur initiale.

Par impureté, on entend tout élément, molécule, ion, ou autre, différent des éléments constitutifs de l'eau pure, à savoir H₂O, OH⁻, et H⁺.

Ce procédé de purification peut être, par exemple, un procédé de désalinisation par exemple de l'eau de mer, un procédé de traitement des eaux de productions industrielles, ou un procédé de traitement des lixiviats de décharge.

Le domaine technique de l'invention peut donc être défini de manière générale comme celui de la formation, cristallisation de clathrates hydrates notamment à des fins de purification d'un liquide aqueux.

### ÉTAT DE LA TECHNIQUE ANTÉRIEURE

Rappelons tout d'abord que le mot « clathrate » provient du grec « Klathron » qui signifie fermeture. Les clathrates désignent une famille de structures cristallines sous forme de cage capable de piéger en leur coeur une molécule dite molécule hôte.

Dans le cas des hydrates, les molécules d'eau s'organisent sous forme de cage uniquement maintenue par des liaisons faibles du type liaison hydrogène et piègent en leur coeur une molécule hôte.

Les clathrates les plus connus sont les gaz-hydrates qui comprennent une molécule hôte qui est gazeuse comme le méthane, l'éthane, le butane, le propane, le sulfure d'hydrogène, ou le gaz carbonique. Ces gaz-hydrates se forment dans des conditions de pression et de température bien précises, à savoir (généralement à des pressions de plusieurs dizaines d'atmosphères et à des températures légèrement supérieures à 0°C) en fonction de la nature du ou des gaz. Certains hydrocarbures, comme le clathrate de cyclopentane, cristallisent cependant sous pression atmosphérique jusqu'à 7°C.

Par leur nature « anionique » structurelle, les clathrates hydrates ont la singularité de cristalliser de manière très sélective, c'est-à-dire sans inclure d'impuretés au sein de leur édifice cristallin. Leur cristallisation est donc quasiment indépendante de la nature et de la concentration des différentes impuretés présentes dans la solution, seule la température de cristallisation du clathrate hydrate est susceptible de varier en fonction de la nature et de la concentration en impuretés.

Dans une solution riche en impuretés et contenant des molécules hôtes susceptibles de former un clathrate, la cristallisation de l'hydrate en pompant des molécules d'eau contribue à concentrer la solution en impuretés. En d'autres termes, la cristallisation du clathrate a pour effet d'extraire les molécules d'eau de la solution tant que les molécules hôtes sont disponibles. Par exemple, le document US 2003/209492 décrit un procédé de cristallisation de clathrates hydrates dans un système aqueux comprenant des impuretés salines, le liquide étant refroidi. Les hydrates sont formés par injection gazeuse dans le liquide à purifier et se rassemblent dans une couche poreuse.

Une fois séparé de la phase liquide, la fusion de l'hydrate permet d'obtenir à des températures comprises entre 0°C et 10°C une eau d'une extrême pureté si la molécule hôte est aisément séparable sous forme de gaz ou par décantation pour les hydrocarbures insolubles tels que le cyclopentane.

En conditions maîtrisées, la cristallisation de clathrates hydrates, notamment de cyclopentane, est relativement aisée.

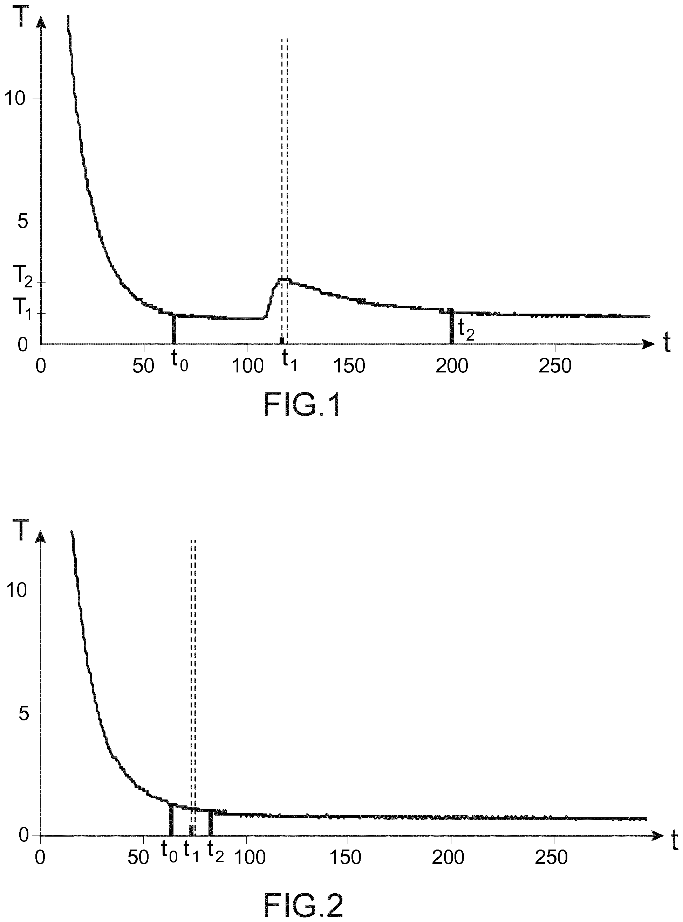

Sur la Figure 1 est représenté un exemple d'une courbe qui donne la température T (en °C) d'un liquide aqueux, telle qu'une solution aqueuse, lors de la cristallisation d'un clathrate hydrate d'une molécule hôte, telle que le cyclopentane dans ce liquide aqueux en fonction du temps t (en minutes), cette cristallisation étant réalisée par un procédé classique, non conforme à l'invention.

Cette courbe permet d'apprécier aussi bien la consommation d'énergie lors de la cristallisation des clathrates hydrates que la cinétique de cette cristallisation.

En ce qui concerne la consommation d'énergie, cette courbe met en évidence que deux apports énergétiques sont nécessaires lors de la cristallisation.

Tout d'abord, lors d'une première étape, le liquide est refroidi depuis la température ambiante, par exemple 25°C, jusqu'à une température T₁ inférieure à la température de cristallisation de l'hydrate, et on introduit alors les molécules hôtes dans le liquide au temps t₀.

Sur la Figure 1, à titre d'exemple, le temps to est d'environ 60 minutes, et la température T₁ est maintenue jusqu'à ce qu'apparaissent les premiers cristaux d'hydrate, autrement dit jusqu'à ce que se produise une nucléation de l'hydrate, indiquée par un changement de phase avec apparition d'une phase solide d'hydrate. Cette nucléation se produit au temps t₁. Sur la figure 1, à titre d'exemple, le temps t₁ est d'environ 120 minutes.

Il peut exister une durée de latence entre le temps t₀ et le temps t₁.

Sur la figure 1, à titre d'exemple, cette durée de latence est d'environ 50 à 60 minutes entre t₀ et t₁.

La durée t₁-t₀ est très variable et aléatoire, la nucléation est dite « stochastique ».

La température T₁ est inférieure à la température de cristallisation de l'hydrate pour pouvoir initier la cristallisation, elle dépend donc de l'hydrate ainsi que de la molécule hôte. Cette température T₁ est inférieure à 7°C dans le cas où la molécule hôte est le cyclopentane.

Sur la Figure 1 à titre d'exemple, la température T₁ est voisine de 1°C, et elle est donc bien inférieure à 7°C.

Ensuite, lors d'une deuxième étape qui débute donc au temps t₁, la structure cristalline de l'hydrate se construit.

Il s'agit là d'une réaction exothermique avec un ΔH de l'ordre de 280 KJ/Kg d'hydrate si la molécule hôte est du cyclopentane, soit de l'ordre de 350 KJ/Kg d'eau cristallisée sous forme d'hydrate.

De ce fait, la courbe de la Figure 1 présente un pic exothermique dû à la formation de l'hydrate, avec changement de phase, entraînant une augmentation de la température du liquide jusqu'à une température T₂.

Ce pic exothermique, avec une augmentation de température, doit être compensé par un refroidissement supplémentaire, ce qui implique une consommation d'énergie.

Du fait de ce refroidissement, la température du liquide diminue, jusqu'à revenir à la température T₁ et que le pic exothermique disparaisse au temps t₂.

La première et la deuxième étapes constituent le procédé proprement dit de cristallisation, formation des hydrates.

Ces étapes, lorsqu'elles sont intégrées dans un procédé de purification sont généralement réalisées dans un réacteur-décanteur, et sont généralement suivies comme on l'a déjà évoqué plus haut d'une étape de séparation des clathrates hydrate du liquide puis d'une étape de dissociation des clathrates hydrates, généralement par fusion.

Ainsi, sur la courbe de la Figure 1, après le pic exothermique et le temps t₂, la réaction de formation des clathrates hydrates étant achevée, on arrête le refroidissement, et l'hydrate fond.

La consommation d'énergie lors de la première étape de refroidissement, jusqu'à t₁, est généralement d'environ 20% de la consommation totale d'énergie lors du procédé continu de formation des hydrates, puisqu'il faut de l'ordre de 4 KJ/Kg de solution pour refroidir la solution d'un degré Celsius, soit 96 KJ/Kg pour faire passer la solution de 25 °C à 1°C ; tandis que la consommation d'énergie lors de la deuxième étape de refroidissement, entre t₁ et t₂, est généralement d'environ 80% de la consommation totale d'énergie lors du procédé de formation des hydrates puisqu'il faut compenser l'exothermie de l'ordre de 350 KJ par Kg d'eau correspondant à la cristallisation de l'hydrate.

La consommation totale, globale, d'énergie du procédé de formation des hydrates à partir d'une solution à 25°C est élevée, elle peut atteindre par exemple, en présence de NaCl et dans des conditions eutectiques impliquant un refroidissement jusqu'à une température de l'ordre de -15°C, par exemple 45 KWh/m³ d'eau pour la première étape de refroidissement, et par exemple 97 KWh/m³ d'eau lors de la deuxième étape de refroidissement.

Il existe donc un besoin pour un procédé de formation, cristallisation d'hydrates dont la consommation d'énergie soit moindre.

En ce qui concerne la cinétique d'un procédé de cristallisation classique, on constate sur la courbe de la Figure 1 qu'elle est relativement lente. Par exemple, le temps t₁ est d'environ 120 minutes tandis que la durée entre t₂ et t₁, c'est-à-dire la durée du pic exothermique est généralement de 80 minutes.

Par ailleurs, on sait que les hydrates se forment à l'interface entre la molécule hôte et l'eau et que la cinétique de cristallisation, formation des hydrates, c'est-à-dire la cinétique de la réaction entre l'eau et la molécule hôte est conditionnée par la surface de contact entre la molécule hôte et l'eau. Plus la surface de contact est élevée, meilleure sera la cinétique.

Dans le cas où la molécule hôte est une molécule insoluble dans l'eau telle que le cyclopentane, la surface de contact est très faible, la cinétique est donc extrêmement lente, et on doit alors utiliser un dispersant chimique liquide comme un composé de type TWEEN® ou SPAN, ou alors mettre en oeuvre une agitation mécanique très dynamique, pour disperser dans l'eau la molécule hôte insoluble sous la forme de fines gouttelettes formant une émulsion, et accroître ainsi la surface de contact entre l'eau et la molécule hôte.

La cinétique est alors améliorée, et l'on produit facilement plus d'hydrate, mais le dispersant reste dans l'eau et le procédé présente alors l'inconvénient de nécessiter une étape ultérieure de séparation, élimination du dispersant liquide par exemple par absorption.

Enfin, le rendement du procédé de cristallisation est encore insuffisant.

Il existe donc un besoin pour un procédé de formation, cristallisation d'hydrates dont la cinétique, soit améliorée sans qu'il soit cependant nécessaire d'utiliser des dispersants liquides.

Il existe encore un besoin pour un procédé de formation, cristallisation d'hydrates dont le rendement soit amélioré.

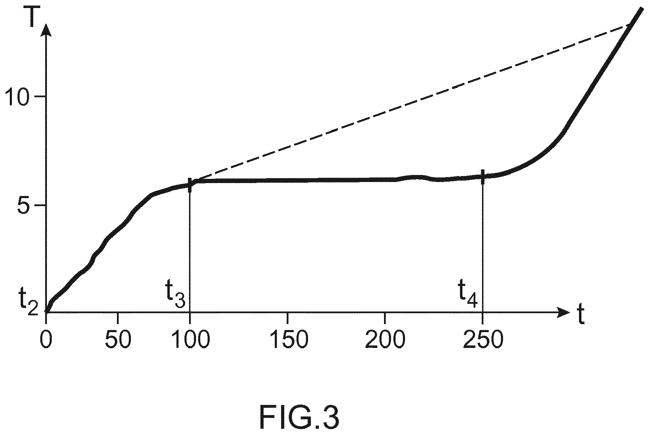

Si l'on s'intéresse maintenant à la courbe T(t) après le temps t₂ (Figure 3), on procède alors généralement à la dissociation des hydrates par fusion. Ainsi après t₂, le refroidissement ayant cessé, on observe une augmentation de la température du liquide comprenant de l'eau et des hydrates, puis les hydrates fondent et se dissocient, et la température demeure constante pendant une durée comprise entre les temps t₃ correspondant au début de la fusion, et t₄. La courbe T(t) présente donc entre les temps t₃ et t₄, un palier de température ou palier de fusion qui correspond à un endotherme de fusion. Après la fin de ce palier, au temps t₄, les hydrates sont complétement dissociés, le liquide comprend de l'eau et des molécules hôtes telles que du cyclopentane, et la température du liquide augmente.

On comprend que l'endotherme de fusion génère des frigories qu'il est intéressant de récupérer avec une pompe à chaleur pour les réinjecter dans l'étape amont de cristallisation d'un procédé continu mettant en oeuvre une étape de cristallisation des hydrates et une étape de fusion des hydrates. La pompe à chaleur améliore la consommation énergétique du procédé mais alourdit significativement son coût matériel. Le but de la présente invention est de fournir un procédé de formation, cristallisation d'hydrates qui réponde entre autres aux besoins énumérés plus haut, qui ne présente pas les inconvénients, défauts, limitations et désavantages des procédés de formation, cristallisation d'hydrates de l'art antérieur et qui résolve les problèmes des procédés formation, cristallisation d'hydrates de l'art antérieur.

Le but de la présente invention est encore de fournir un procédé de purification d'un liquide aqueux, qui ne présente pas les inconvénients, défauts, limitations et désavantages de tels procédés de l'art antérieur et qui résolve les problèmes de tels procédés de l'art antérieur notamment en ce qui concerne l'étape de dissociation, fusion, des hydrates.

### EXPOSÉ DE L'INVENTION

Ce but, et d'autres encore, sont atteints, conformément à l'invention par un procédé pour former, cristalliser des clathrates hydrates d'une molécule hôte dans un liquide comprenant de l'eau, caractérisé en ce qu'on réalise les étapes successives suivantes :
- on refroidit le liquide jusqu'à une température inférieure ou égale à la température de cristallisation des clathrates hydrates ;
- on introduit dans le liquide refroidi des molécules hôtes capables de former des clathrates hydrates, adsorbées sur un support solide de grande surface spécifique en un matériau hydrophobe et apolaire, moyennant quoi les molécules hôtes sont désorbées du support solide de grande surface spécifique en un matériau hydrophobe et apolaire et réagissent avec l'eau du liquide pour donner un liquide contenant des clathrates hydrates et le support solide.

Autrement dit, les molécules hôtes se séparent (se désorbent) du support solide pour former des clathrates hydrates, tandis que séparément le support solide exempt d'hydrates demeure dans le liquide.

Par grande surface spécifique, on entend généralement une surface spécifique de 100 à 2000 m²/g.

Dans la présente, on emploie souvent, par simplification, le terme « hydrate » au lieu de « clathrate hydrate ».

Le procédé selon l'invention pour former (cristalliser) des clathrates hydrates d'une molécule hôte dans un liquide comprenant de l'eau, est fondamentalement défini par la caractéristique selon laquelle on introduit dans le liquide des molécules hôtes capables de former des clathrates hydrates, ces molécules hôtes étant, selon l'invention, préalablement adsorbées sur un support solide de grande surface spécifique en un matériau hydrophobe et apolaire.

Cette caractéristique essentielle du procédé selon l'invention n'a jamais été décrite ou suggérée dans l'art antérieur.

On peut dire que selon l'invention la molécule hôte, notamment liquide et insoluble dans l'eau, telle que le cyclopentane, au lieu d'être dispersée sous la forme de fines gouttelettes dispersées dans le liquide aqueux, est, de manière surprenante et avantageuse, adsorbée sur un support catalytique très réactif du fait de sa grande surface spécifique.

En d'autres termes dans le procédé selon l'invention, on étale la molécule hôte, notamment liquide et insoluble dans l'eau, telle que le cyclopentane, sur un support catalytique de grande surface spécifique, par exemple sur du charbon actif.

Selon l'invention, le support catalytique de grande surface spécifique est en un matériau spécifique, à savoir un matériau hydrophobe et apolaire, par exemple du charbon ou du carbone, pour éviter l'adsorption de l'eau sur ce support solide, et pour que seule la molécule hôte, notamment liquide et insoluble dans l'eau, telle que le cyclopentane s'adsorbe sur le support solide.

Dans le procédé selon l'invention, du fait de la mise en oeuvre d'un support solide de grande surface spécifique en un matériau hydrophobe et apolaire, la molécule hôte, notamment liquide et insoluble dans l'eau, telle que le cyclopentane se trouve sur le support à l'état moléculaire et non plus sous la forme de fines gouttelettes. Grâce au support solide utilisé selon l'invention, il n'y a plus de telles gouttelettes fines ou microgouttelettes dans le liquide, et tout le cyclopentane est « réactif » car il est adsorbé sur la surface du support solide notamment en charbon actif. En outre, Il n'y a plus de phénomène d'encapsulation des gouttelettes de cyclopentane sous l'effet de la cristallisation de l'hydrate en surface de ces dernières.

La surface de contact entre la molécule hôte, notamment liquide et insoluble dans l'eau, telle que le cyclopentane et l'eau, autrement dit l'interface entre la molécule hôte et l'eau se trouve donc, selon l'invention, considérablement accrue, et quasiment chaque molécule hôte est disponible pour former des clathrates avec l'eau par désorption du support.

Or, comme on l'a déjà vu plus haut, on sait que les hydrates se forment à l'interface entre la molécule hôte et l'eau et que la cinétique de cristallisation, formation des hydrates, c'est-à-dire la cinétique de la réaction entre l'eau et la molécule hôte est, entre autres, conditionnée par la surface de contact entre la molécule hôte et l'eau. De ce fait, dans le procédé selon l'invention, la cinétique de formation des hydrates est considérablement accrue.

Dans le procédé selon l'invention, la molécule hôte telle que le cyclopentane, n'est jamais libre, elle est toujours captive, car elle est soit intégrée dans l'hydrate, soit adsorbée sur le support par exemple en charbon actif.

Grâce à la caractéristique fondamentale du procédé selon l'invention, exposée plus haut (à savoir la caractéristique selon laquelle on introduit dans le liquide des molécules hôtes capables de former des clathrates hydrates, ces molécules hôtes étant selon l'invention, adsorbées sur un support solide de grande surface spécifique en un matériau hydrophobe et apolaire), les inconvénients des procédés pour former (cristalliser) des clathrates hydrates de l'art antérieur sont surmontés et les problèmes des procédés pour former (cristalliser) des clathrates hydrates de l'art antérieur sont résolus.

Le procédé selon l'invention permet de surmonter les problèmes des procédés de l'art antérieur notamment en ce qui concerne la consommation d'énergie, la cinétique, et le rendement.

Ainsi, en ce qui concerne la consommation d'énergie qui est le poste impliquant les coûts les plus élevés, le procédé selon l'invention permet de diminuer de manière conséquente la consommation d'énergie, et donc de réduire de manière importante les coûts afférents.

Sur la Figure 2 est représentée une courbe qui donne la température T (en °C) d'un liquide aqueux, telle qu'une solution aqueuse lors de la cristallisation d'un clathrate hydrate d'une molécule hôte, telle que le cyclopentane dans ce liquide aqueux en fonction du temps t (en minutes), cette cristallisation étant réalisée par le procédé selon l'invention.

Si l'on compare cette courbe à celle de la Figure 1, qui est celle correspondant à un procédé classique, on constate de manière totalement surprenante que le pic exothermique de la courbe de la Figure 1 entre les temps t₁ et t₂ a totalement disparu.

Or comme on l'a vu plus haut, la consommation d'énergie lors de la deuxième étape de refroidissement, entre t₁ et t₂, afin de compenser le pic exothermique, est généralement d'environ 80% de la consommation totale d'énergie lors du procédé de formation des hydrates. Avec le procédé selon l'invention, il n'est plus nécessaire de consommer de l'énergie pour compenser ce pic exothermique, et on réalise un gain considérable d'environ 90% à 95% sur la consommation d'énergie, lors de cette deuxième étape de refroidissement, et le gain sur la consommation globale d'énergie du procédé est d'environ 72 à 76%

La consommation totale, globale, d'énergie du procédé de formation d'hydrates selon l'invention n'est ainsi par exemple que de 10 KWh/m³ alors qu'elle était de 45 KWh/m³ pour les procédés de l'art antérieur mettant bien sûr en oeuvre le même liquide aqueux et la même molécule hôte, et un dispositif de pompe à chaleur. Les avantages qui en découlent sont notamment un dimensionnement moins important de l'installation et la suppression d'une pompe à chaleur.

Sans vouloir être lié par aucune théorie, la disparition du pic exothermique serait due au fait que le procédé selon l'invention fait intervenir simultanément d'une part une réaction de désorption de la molécule hôte, telle que le cyclopentane, depuis le support solide qui est une réaction endothermique, et d'autre part une réaction de cristallisation de l'hydrate qui est une réaction exothermique.

L'énergie dégagée par la réaction exothermique est donc presque totalement voire totalement absorbée par la réaction endothermique et le pic exothermique est presque notamment voire totalement supprimé.

En ce qui concerne la cinétique, comme on l'a déjà exposé plus haut, la cinétique de formation des hydrates est considérablement accrue. La cristallisation totale des hydrates est de manière complètement surprenante, extrêmement rapide.

Dans les procédés de l'art antérieur, cette cristallisation se déroule entre les temps t₁ et t₂, et sa durée est celle du pic exothermique.

Dans le procédé selon l'invention, le pic exothermique est supprimé et la cristallisation totale des hydrates se produit immédiatement ou quasiment immédiatement après t₁ et la durée de la cristallisation est extrêmement courte.

A titre d'exemple, la cristallisation totale des hydrates peut, dans le procédé, selon l'invention prendre moins de 2 minutes, alors que dans les procédés de l'art antérieur, la durée pour obtenir une cristallisation totale des hydrates entre les temps t₁ et t₂ est par exemple de 80 minutes (voir Figure 2).

La grande disponibilité de la molécule hôte dans le procédé selon l'invention, entraîne un gain considérable sur le rendement de transformation de la molécule hôte, par exemple par rapport aux procédés dans lesquels la molécule hôte se trouve sous la forme de gouttelettes très fines.

Un autre avantage du procédé selon l'invention, qui est particulièrement mis en évidence dans le cas où la molécule hôte est une molécule insoluble dans l'eau, telle que le cyclopentane, est que l'on n'utilise pas dans le procédé selon l'invention de dispersant chimique liquide comme un composé de type TWEEN® ou SPAN, et que l'on ne met pas en en oeuvre une agitation mécanique très dynamique pour disperser dans l'eau la molécule hôte insoluble. En conséquence, par rapport aux procédés qui mettent en oeuvre de tels dispersants chimiques liquides, le procédé selon l'invention présente l'avantage de ne pas nécessiter d'étape ultérieure de séparation, élimination du dispersant liquide, par exemple par absorption.

Le procédé selon l'invention peut en outre être mis en oeuvre avec succès dans une très large gamme de température, aussi bien à l'eutectique qu'en dehors de l'eutectique.

Avantageusement, le procédé selon l'invention peut être réalisé en continu.

Avantageusement, on peut mettre en contact (en dehors du liquide) les molécules hôtes et le support solide de grande surface spécifique moyennant quoi les molécules hôtes sont adsorbées sur le support solide de grande surface spécifique, puis on introduit le support solide de grande surface spécifique sur lequel sont adsorbées les molécules hôtes dans le liquide.

Avantageusement, le support solide peut se présenter sous la forme de particules discrètes, telles que des billes, fibres, ou tubes.

Les billes, par exemple les billes en charbon actif, peuvent avoir un diamètre de 0,2 à 1,5 mm.

Un support solide sous la forme de billes est particulièrement avantageux, car de telles billes ne sont pas sujettes à une attrition, sont quasiment inusables, et peuvent être récupérées à l'issue du procédé et réutilisées de manière quasiment infinie.

Des billes de charbon actif qui se sont avérées particulièrement avantageuses pour mettre en oeuvre le procédé selon l'invention sont les billes G BAC G70R de chez Kureha®, qui subissent très peu d'attrition.

Ou bien, le support solide peut se présenter sous la forme d'un tissu de fibres ou d'un non-tissé de fibres.

Généralement, le support solide peut être en un matériau choisi parmi tous les matériaux qui permettent l'adsorption et la désorption de la molécule hôte.

Généralement, le support solide adsorbant est en un matériau choisi parmi les matériaux capables d'adsorber la molécule hôte avec une énergie d'adsorption inférieure à l'énergie de cristallisation des clathrates hydrates.

Avantageusement, le support solide adsorbant peut être en un matériau choisi parmi le charbon actif ; les oxydes de métaux tels que les alumines ; les oxydes de métalloïdes tels que les silices, notamment les silices mésoporeuses ; les zéolithes ; et les polymères organiques, etc.

La molécule hôte est généralement choisie parmi les molécules qui satisfont aux deux critères suivants :
(1) elle doit être capable de s'adsorber sur le support solide, par exemple en charbon actif ;
(2) elle doit former des hydrates.

De manière générale, on peut aussi considérer que le support et la molécule hôte sont choisis de façon à ce que l'énergie de liaison entre la molécule hôte (par exemple le Cyclopentane) et le support (par exemple en charbon actif) ne soit pas trop élevée. En effet, si cette énergie de liaison est trop forte alors la molécule hôte n'est pas disponible pour former l'hydrate.

La molécule hôte peut être notamment choisie parmi les hydrocarbures linéaires ou ramifiés comprenant de 1 à 6 atomes de carbone tels que le méthane, l'éthane, les propanes, et les butanes ; les hydrocarbures halogénés ; les hydrocarbures cycliques comprenant de 3 à 10 atomes de carbone ; le CO₂; l'oxygène ; l'azote ; le H₂S ; les gaz rares comme l'argon, le krypton et le xénon ; le tétrahydrofuranne ; l'oxyde d'éthylène ; l'hexafluorure de soufre ; le bromure de tétra-n-butylammonium (TBAB); et le N₂O.

Les molécules hôtes gazeuses nécessitent généralement des pressions élevées, à savoir de 0,5 MegaPascal à 5 MegaPascal.

Avantageusement, la molécule-hôte est immiscible avec l'eau, ou insoluble dans l'eau.

Avantageusement, la molécule-hôte est choisie parmi les molécules hôtes qui permettent de cristalliser des clathrates hydrates à la pression atmosphérique et à des températures supérieures à celle de la cristallisation de la glace.

Avantageusement, la molécule-hôte est choisie parmi les molécules qui forment un clathrate hydrate ayant une densité inférieure à la densité de la solution aqueuse, par exemple inférieure à 1,3, de préférence inférieure à 1,0.

Une molécule-hôte préférée est le cyclopentane ou le cyclohexane.

En effet, le clathrate hydrate de cyclopentane associe 17 molécules d'eau par molécule de cyclopentane dans la structure [C₅H₁₀].17H₂O.

Le cyclopentane permet de cristalliser des clathrates hydrates sous pression atmosphérique à des températures supérieures à la température de cristallisation de la glace, puisque le clathrate hydrate de cyclopentane présente une température de cristallisation (ou température d'équilibre) d'environ 7°C en présence d'eau pure.

Le cyclopentane est à l'état liquide dans les conditions normales. Il est immiscible dans l'eau et permet de cristalliser des clathrates hydrates de densité inférieure à celle de l'eau, car le clathrate hydrate de cyclopentane a une densité de 0,95.

Généralement, le liquide comprenant de l'eau peut comprendre de l'eau et au moins une impureté.

Le liquide peut être une solution contenant des impuretés dissoutes ou une suspension contenant des impuretés dispersées, en suspension, ou bien encore une solution contenant des impuretés dissoutes et des impuretés en suspension dans ladite solution.

Avantageusement, le liquide est une solution aqueuse.

Il n'existe aucune limitation sur la ou les impureté(s) que contient le premier liquide et le procédé selon l'invention assure la purification de liquides quelles que soient les impuretés qu'ils contiennent.

Par impureté, comme on l'a déjà précisé, on entend tout élément, molécule, ion, ou autre, différent des éléments constitutifs de l'eau pure, à savoir H₂O, OH⁻, et H⁺.

L'impureté peut être notamment choisie parmi les sels minéraux tels que NaCl, les sels organiques, les composés organiques solubles dans l'eau, et leurs mélanges.

Le procédé selon l'invention assure également la purification de liquides qui possèdent de larges gammes de concentrations en impuretés.

Le liquide peut avoir notamment une concentration en impureté(s) de 1 mg/L à 500 g/L, de préférence de 100 mg/L à 250 g/L.

Il n'existe en conséquence également aucune limitation sur la nature du liquide qui peut être utilisé dans le procédé selon l'invention et qui peut être traité par le procédé de purification selon l'invention décrit plus bas.

Le liquide peut ainsi être notamment choisi parmi l'eau de mer ; les eaux saumâtres ; les lixiviats de décharges publiques ; les eaux de production pétrolière ; les eaux d'extraction du gaz de schiste par la technique de fracturation hydraulique ; les liquides de l'industrie agroalimentaire tels que les jus de fruits ou le café ; les liquides de l'industrie pharmaceutique ; les liquides de l'industrie chimique ; les effluents miniers, par exemple les rejets miniers chargés en sulfates, phosphates ou carbonates ; les effluents de l'industrie métallurgique; les effluents de l'industrie nucléaire ; les concentrâts d'osmose inverse ; les solutions entartrantes ; les effluents de l'industrie papetière ; les aquifères salins.

Le procédé selon l'invention peut utiliser des solutions très concentrées en impuretés, notamment en NaCl, par exemple avec des concentrations au-delà de 150 g/L.

Le procédé de purification selon l'invention, décrit plus bas, permet notamment de traiter des solutions très concentrées en impuretés, notamment en NaCl, par exemple avec des concentrations au-delà de 150 g/L.

Le liquide peut donc être choisi parmi les solutions aqueuses de NaCl dont la concentration en NaCl est supérieure à 150 g/L.

Le procédé de formation, cristallisation de clathrates hydrates selon l'invention peut être intégré dans tout procédé comprenant au moins une étape de formation, cristallisation de clathrates hydrates. Le procédé dans lequel se trouve intégrée cette étape de formation, cristallisation de clathrates hydrates selon l'invention possède tous les avantages liés de manière inhérente au procédé de cristallisation de clathrates hydrates selon l'invention.

On peut dire que, dans le procédé selon l'invention, dès lors que la molécule hôte est absorbée sur le support, celui-ci est analogue à un matériau à changement de phase, il se comporte de manière analogue et peut donc être utilisé dans tout procédé dans lequel peuvent être mis en oeuvre des matériaux à changement de phase, et au cours desquels peuvent notamment se produire une compensation des effets thermiques.

Le procédé comprenant au moins une étape de formation, cristallisation de clathrates hydrates selon l'invention peut être par exemple un procédé de purification de l'eau ou tout autre procédé comprenant une étape de cristallisation d'une phase hydrate, et au cours duquel peut se produire une compensation des effets thermiques.

L'invention a trait en outre à un procédé de purification d'un liquide comprenant de l'eau et au moins une impureté, dans lequel on réalise les étapes successives suivantes :
a1) on forme des clathrates hydrates de la molécule hôte dans le liquide par le procédé décrit plus haut;
b1) on sépare les clathrates hydrates et le support solide du liquide ;
c1) on dissocie les clathrates hydrates séparés pour obtenir d'une part de l'eau pure et d'autre part la molécule hôte de nouveau adsorbée sur le support.

Outre, les effets avantageux dus au fait que l'étape a1) est réalisée par le procédé selon l'invention, le procédé de purification selon l'invention présente également d'autres avantages essentiellement dus à la mise en oeuvre d'un support solide qui adsorbe les molécules hôtes.

Dans le procédé de purification selon l'invention, la molécule hôte telle que le cyclopentane, n'est jamais libre, tout au long de ce procédé, elle est toujours captive, car elle est soit intégrée dans l'hydrate, soit adsorbée sur le support par exemple en charbon actif.

L'étape b1) est généralement réalisée par filtration.

Lors de l'étape b1), le support solide par exemple en charbon actif agit comme un milieu de séparation (lit de filtration), et assure donc une séparation, filtration meilleure et plus rapide.

Généralement, lors de l'étape c1) on dissocie les clathrates hydrates en les faisant fondre et l'étape c1) est donc une étape de fusion des clathrates hydrates.

Lors de l'étape c1), dès que les hydrates fondent, la molécule hôte, telle que le cyclopentane est totalement complétement réadsorbée, adsorbée de nouveau sur le support solide.

Ainsi, grâce au support solide, par exemple en charbon actif, l'endotherme de fusion des hydrates (entre t₃ et t₄ sur la courbe en traits pleins de la Figure 3) est compensé par l'exotherme de l'adsorption de la molécule hôte, telle que le cyclopentane sur le support (voir courbe pointillée sur la Figure 3). La consommation d'énergie est là-aussi fortement réduite et il est possible de supprimer la pompe à chaleur.

Dans le procédé de purification selon l'invention qui met en oeuvre un support solide, on obtient une eau d'une très grande pureté, exempte notamment de molécule hôte et en tout cas d'une bien plus grande pureté que l'eau obtenue par un procédé de purification de l'art antérieur qui ne met pas en oeuvre de support solide.

A titre d'exemple, avec un procédé de purification de l'eau l'art antérieur utilisant du cyclopentane en tant que molécule hôte qui ne met pas en oeuvre de support solide et notamment pas de charbon actif, l'eau contient encore 100 ppm de cyclopentane, tandis qu'avec le procédé de purification selon l'invention qui met en oeuvre du charbon actif, le cyclopentane ne peut être détecté et sa teneur se situe en-dessous des limites de détection.

Avantageusement, dans le procédé de purification d'un liquide selon l'invention la molécule hôte adsorbée sur le support solide obtenue à l'issue de l'étape c1) est renvoyée, recyclée, dans l'étape a1).

Deux modes de réalisation sont possibles pour effectuer ce recyclage de la molécule hôte adsorbée sur le support solide.

Selon un premier mode de réalisation, la molécule hôte adsorbée sur le support solide peut être recyclée sous la forme d'une suspension aqueuse, comprenant une quantité d'eau minimale, c'est-à-dire la quantité d'eau qui est juste nécessaire pour permettre une manipulation, un transport hydraulique. Cette suspension aqueuse peut être acheminée vers l'étape a1) par tout moyen de transport hydraulique adéquat par exemple à l'aide de pompes, canalisations etc.

Selon un second mode de réalisation, la molécule hôte adsorbée sur le support solide peut être recyclée sous forme solide, par exemple sous la forme d'un gâteau (« cake ») de filtration. Ce solide peut être acheminé vers l'étape a1) par tout moyen de transport de solide adéquat, par exemple sur des bandes transporteuses etc.

Grâce à ce recyclage, la consommation de molécule hôte se trouve considérablement réduite, ce qui diminue également le coût global du procédé de purification selon l'invention.

### BRÈVE DESCRIPTION DES DESSINS

- La Figure 1 est un graphique qui donne la Température du liquide (T en °C) en fonction du temps (t en minutes) lors du refroidissement du liquide et de la cristallisation des clathrates hydrates dans un procédé de cristallisation d'hydrates de l'art antérieur qui ne met pas en oeuvre de support solide, par exemple en charbon actif.
- La Figure 2 est un graphique qui donne la Température du liquide (T en °C) en fonction du temps (t en minutes) lors du refroidissement du liquide et de la cristallisation des clathrates hydrates dans un procédé de cristallisation d'hydrates selon l'invention qui met en oeuvre un support solide, par exemple en charbon actif.
- La Figure 3 est un graphique qui donne la Température du liquide (T en °C) en fonction du temps (t en minutes) lors de l'étape de fusion des clathrates hydrates, dans un procédé de purification ou de transport de l'art antérieur qui ne met pas en oeuvre de support solide par exemple en charbon actif (courbe en trait plein) ou dans un procédé de purification qui met en oeuvre un support solide par exemple en charbon actif (courbe en traits pointillés).

L'origine des temps se situe à t₂.

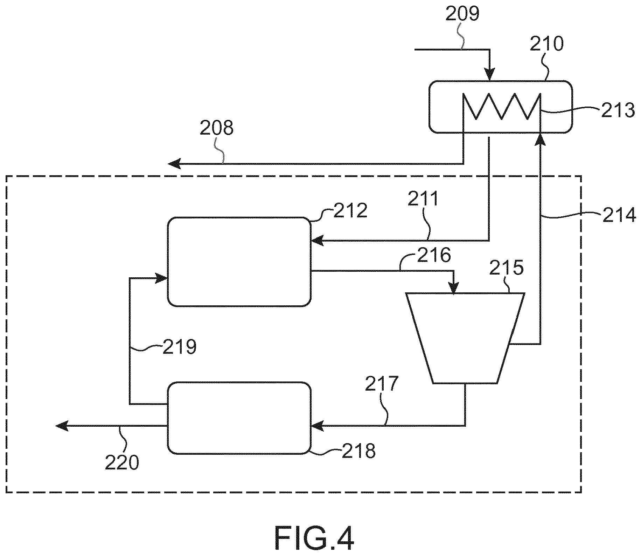

- La Figure 4 est une vue schématique qui illustre une installation pour la mise en oeuvre du procédé de purification selon l'invention qui utilise des clathrates hydrates cristallisés par le procédé de cristallisation de clathrates selon l'invention, ainsi que la mise en oeuvre du procédé de purification selon l'invention dans cette installation.

### EXPOSÉ DÉTAILLÉ DE MODES DE RÉALISATION PARTICULIERS

La Figure 4 est une vue schématique qui montre une forme de réalisation d'une installation pour la mise en oeuvre du procédé de purification selon l'invention, mis en oeuvre en continu, pour purifier une eau chargée en impuretés, telle qu'une solution aqueuse chargée en impuretés, par exemple une solution aqueuse saline contenant majoritairement du NaCl et d'autres impuretés.

Il est bien évident que cette solution aqueuse saline n'est donnée qu'à titre d'exemple, et que le procédé illustré sur la Figure 4 peut être utilisé pour purifier toute eau chargée en impuretés.

La solution à traiter est acheminée par une canalisation 209 dans un dispositif réfrigérant 210. Cette solution à traiter, purifier, est ensuite envoyée par l'intermédiaire d'une canalisation 211, dans un réacteur de cristallisation et de croissance des clathrates hydrates 212 dans lequel on a introduit des molécules hôtes, par exemple du cyclopentane, adsorbées sur un support solide, par exemple en charbon actif

Le dispositif réfrigérant 210 comprend un échangeur de chaleur 213 dans lequel se produit un échange de chaleur entre la solution à traiter et la solution concentrée en impuretés qui circule dans une canalisation 214 puis dans une canalisation 208.

Les échangeurs de chaleur adéquats sont connus de l'homme du métier et ne seront donc pas décrits plus en détail.

L'eau contenue dans la solution à purifier refroidie acheminée par la canalisation 211, et les molécules hôtes adsorbées sur un support solide qui se trouvent dans le réacteur 212 forment des clathrates hydrates qui croissent dans ce réacteur de cristallisation et de croissance des clathrates hydrates 212.

En tant que molécule hôte, on peut utiliser de préférence le cyclopentane, mais d'autres molécules hôtes peuvent aussi être utilisées, par exemple des molécules gazeuses comme le méthane, l'éthane, le butane, le propane, le sulfure d'hydrogène, le gaz carbonique, ou leurs mélanges.

Généralement, la molécule hôte est choisie de façon à ne pas influencer le reste du procédé. En conséquence, la molécule hôte peut être choisie selon des critères économiques ou autres.

Il est particulièrement avantageux d'utiliser le cyclopentane comme molécule hôte, car il permet de former les clathrates hydrates dans le réacteur de cristallisation des clathrates 212 à la pression atmosphérique, à savoir sous une pression de 1 bar et à une température généralement située entre -20°C et 6°C.

Le support solide est de préférence en charbon actif.

Il est à noter que la température à laquelle les clathrates hydrates se forment dans le réacteur 212 dépend de la concentration en impuretés dans le réacteur 212. En effet, généralement, la concentration en impuretés abaisse la température de cristallisation des clathrates.

Comme de l'eau est utilisée pour former les clathrates hydrates dans le réacteur 212, on obtient donc dans le réacteur 212 une suspension de clathrates hydrates et du support solide dans une solution concentrée en impuretés.

La suspension de clathrates hydrates et de support solide dans une solution concentrée en impuretés formée dans le réacteur 212, est soutirée dans le réacteur 212, et est envoyée dans un séparateur 215 par l'intermédiaire d'une canalisation 216.

Dans le séparateur, on sépare les clathrates hydrates et le support solide de la solution concentrée en impuretés en mettant en oeuvre une technique de séparation liquide/solide.

La technique de séparation liquide/solide utilisée pour séparer les clathrates hydrates et le support solide de la solution concentrée en impuretés dépendra du type de clathrates hydrates mais aussi d'autres facteurs. L'homme du métier choisira facilement la technique adéquate en fonction des propriétés des clathrates hydrates comme par exemple leur granulométrie.

Cette technique de séparation liquide/solide peut être choisie par exemple parmi toutes les techniques classiques de séparation liquide/solide, telles que la filtration par exemple avec un filtre presse, la centrifugation.

La solution concentrée en impuretés séparée dans le séparateur 215 et qui ne contient donc plus de clathrates hydrates et de support solide est soutirée, à partir du séparateur 215, par l'intermédiaire de la canalisation 214 qui alimente l'échangeur de chaleur 213 afin de refroidir la solution initiale à purifier 209 dans le dispositif réfrigérant 210.

La solution concentrée en impuretés, après avoir alimenté l'échangeur de chaleur 213 afin de refroidir la solution initiale à purifier 209 dans le dispositif réfrigérant 210, sort de ce dispositif réfrigérant 210 par la canalisation 208 .

Deux variantes sont possibles pour le traitement de cette solution concentrée en impuretés qui circule dans la canalisation 208 :
- Selon une première variante, la solution concentrée est introduite en totalité dans le courant de solution à traiter qui circule dans la canalisation 209. Dans ce cas, les impuretés se concentreront jusqu'à la concentration eutectique. Pour faire cristalliser les hydrates dans le réacteur 212 il faudra donc se placer à une température T inférieure à la température de l'eutectique. Les impuretés, notamment les sels, seront donc soutirées sous forme solide par une purge (non représentée) située à la base du réacteur 212.
- Selon une seconde variante, la solution concentrée est rejetée partiellement pour constituer la purge liquide sous forme de concentrât, et le reste de la solution concentrée, qui n'est donc pas rejeté, est introduit dans le courant de solution à traiter qui circule dans la canalisation 209 (il n'y a donc plus de rejet sous forme solide par une purge située à la base du réacteur 212).
- Plus la proportion de rejet sera faible, plus le concentrât sera concentré, mais plus la solution de cristallisation le sera aussi, donc plus la température de cristallisation des hydrates sera basse. L'eutectique constitue la limite basse de cette variante (plus de rejet liquide).

Les clathrates hydrates et le support solide séparés dans le séparateur 215 sont soutirés dans le séparateur 215 par l'intermédiaire d'une canalisation 217 et acheminés dans un réacteur de dissociation des clathrates hydrates 218, où les clathrates hydrates sont séparés en molécules hôtes et en eau purifiée.

Toute technique de dissociation connue peut être utilisée. Généralement, la dissociation des cristaux d'hydrate cristallisés en eau et en molécules hôtes est réalisée par une augmentation de température conduisant à leur fusion. Autrement dit, les cristaux d'hydrate cristallisés sont fondus ; le réacteur 218 est alors appelé fondoir.

Ensuite, l'eau purifiée d'une part, et les molécules hôtes et le support solide d'autre part, les molécules hôtes étant adsorbées sur le support solide, sont séparés par une technique de séparation liquide/solide comme la décantation ou la filtration.

Ainsi, dans le cas où la molécule hôte est un liquide non miscible avec l'eau, la dissociation par fusion des clathrates hydrates dans le réacteur 218 forme une suspension qui est introduite dans un filtre (non représenté) pour séparer l'eau purifiée de la molécule hôte adsorbée sur le support solide et le support solide.

La molécule hôte adsorbée sur le support solide est recyclée avec le support solide depuis le réacteur 218 dans le réacteur 212 au moyen d'une canalisation 219.

Dans l'installation selon l'invention, les molécules hôtes et le support solide sont donc recyclés et utilisés de nouveau ce qui accroît la rentabilité de l'installation.

L'eau purifiée est évacuée du réacteur 218 ou du filtre par l'intermédiaire d'une canalisation 220 et peut être utilisée.

On note que l'installation pour la mise en oeuvre du procédé de purification selon l'invention, représentée sur la Figure 4, ne comporte pas d'échangeur de chaleur tel qu'une pompe à chaleur qui fonctionnerait entre le réacteur de cristallisation et de croissance des clathrates hydrates 212 et le réacteur de dissociation des clathrates hydrates 218.

L'absence d'un tel échangeur de chaleur tel qu'une pompe à chaleur constitue un des avantages du procédé selon l'invention.

Pour optimiser le procédé, il serait cependant intéressant de placer un échangeur thermique entre le réacteur de dissociation des clathrates hydrates tel qu'un fondoir 218 et le courant de solution à traiter ou flux rentrant qui circule dans la canalisation 209.

La chaleur du flux rentrant aiderait alors à faire fondre les hydrates, tandis que le froid provenant du réacteur 218 tel qu'un fondoir permettrait déjà de refroidir le courant de solution à traiter ou flux rentrant avant même qu'il ne pénètre dans le dispositif réfrigérant 210.

## Revendications

1. Procédé pour former, cristalliser des clathrates hydrates d'une molécule hôte dans un liquide comprenant de l'eau, **caractérisé en ce qu'**on réalise les étapes successives suivantes :
- on refroidit le liquide jusqu'à une température inférieure ou égale à la température de cristallisation des clathrates hydrates ;
- on introduit dans le liquide refroidi des molécules hôtes capables de former des clathrates hydrates, adsorbées sur un support solide de grande surface spécifique en un matériau hydrophobe et apolaire, moyennant quoi les molécules hôtes sont désorbées du support solide de grande surface spécifique en un matériau hydrophobe et apolaire et réagissent avec l'eau du liquide pour donner un liquide contenant des clathrates hydrates et le support solide.

2. Procédé selon la revendication 1, dans lequel le support solide a une surface spécifique de 100 à 2000 m2/g.

3. Procédé selon la revendication 1 ou 2, qui est réalisé en continu.

4. Procédé selon l'une quelconque des revendications précédentes, dans lequel le support solide se présente sous la forme de particules discrètes, telles que des billes, fibres, ou tubes.

5. Procédé selon l'une quelconque des revendications précédentes, dans lequel le support solide se présente sous la forme d'un tissu de fibres ou d'un non-tissé de fibres.

6. Procédé selon l'une quelconque des revendications précédentes, dans lequel le support solide est en un matériau choisi parmi les matériaux capables d'adsorber la molécule hôte avec une énergie d'adsorption inférieure à l'énergie de cristallisation des clathrates hydrates ; de préférence le support solide adsorbant est en un matériau choisi parmi le charbon actif; les oxydes de métaux tels que les alumines ; les oxydes de métalloïdes tels que les silices, notamment les silices mésoporeuses ; les zéolithes ; et les polymères organiques.

7. Procédé selon l'une quelconque des revendications précédentes, dans lequel la molécule hôte est choisie parmi les hydrocarbures linéaires ou ramifiés comprenant de 1 à 6 atomes de carbone tels que le méthane, l'éthane, les propanes, et les butanes ; les hydrocarbures halogénés ; les hydrocarbures cycliques comprenant de 3 à 10 atomes de carbone ; le CO₂ ; l'oxygène ; l'azote ; le H₂S ; les gaz rares comme l'argon, le krypton et le xénon ; le tétrahydrofuranne ; l'oxyde d'éthylène ; l'hexafluorure de soufre ; le bromure de tétra-n-butylammonium (TBAB); et le N₂O.

8. Procédé selon l'une quelconque des revendications précédentes, dans lequel la molécule-hôte est immiscible avec l'eau ou insoluble dans l'eau.

9. Procédé selon l'une quelconque des revendications précédentes, dans lequel la molécule-hôte est choisie parmi les molécules hôtes qui permettent de cristalliser des clathrates hydrates à la pression atmosphérique et à des températures supérieures à celle de la cristallisation de la glace.

10. Procédé selon l'une quelconque des revendications précédentes, dans lequel la molécule-hôte est choisie parmi les molécules qui forment un clathrate hydrate ayant une densité inférieure à la densité de la solution aqueuse, par exemple inférieure à 1,3, de préférence inférieure à 1,0.

11. Procédé selon l'une quelconque des revendications précédentes, dans lequel la molécule-hôte est le cyclopentane ou le cyclohexane.

12. Procédé selon l'une quelconque des revendications précédentes, dans lequel le liquide comprenant de l'eau comprend de l'eau et au moins une impureté.

13. Procédé selon la revendication 12, dans lequel le liquide est une solution aqueuse.

14. Procédé selon l'une quelconque des revendications 12 et 13, dans lequel l'impureté est tout élément, molécule, ion, ou autre, différent des éléments constitutifs de l'eau pure, à savoir H₂O, OH⁻, et H⁺.

15. Procédé selon la revendication 14, dans lequel l'impureté est choisie parmi les sels minéraux tels que NaCl, les sels organiques, les composés organiques solubles dans l'eau, et leurs mélanges.

16. Procédé selon l'une quelconque des revendications 12 à 15, dans lequel le liquide est choisi parmi l'eau de mer ; les eaux saumâtres ; les lixiviats de décharges publiques ; les eaux de production pétrolière ; les eaux d'extraction du gaz de schiste par la technique de fracturation hydraulique ; les liquides de l'industrie agroalimentaire tels que les jus de fruits ou le café ; les liquides de l'industrie pharmaceutique ; les liquides de l'industrie chimique ; les effluents miniers, par exemple les rejets miniers chargés en sulfates, phosphates ou carbonates ; les effluents de l'industrie métallurgique; les effluents de l'industrie nucléaire ; les concentrâts d'osmose inverse ; les solutions entartrantes ; les effluents de l'industrie papetière ; les aquifères salins.

17. Procédé selon l'une quelconque des revendications 12 à 16, dans lequel le liquide a une concentration en impureté(s) de 1 mg/L à 500 g/L, de préférence de 100 mg/L à 250 g/L.

18. Procédé selon l'une quelconque des revendications 12 à 17, dans lequel le liquide est choisi parmi les solutions aqueuses de NaCl dont la concentration en NaCl est supérieure à 150 g/L.

19. Procédé de purification d'un liquide comprenant de l'eau et au moins une impureté, dans lequel on réalise les étapes successives suivantes :
a1) on forme des clathrates hydrates de la molécule hôte dans le liquide par le procédé selon l'une quelconque des revendications 12 à 18;
b1) on sépare les clathrates hydrates et le support solide du liquide ;
c1) on dissocie les clathrates hydrates séparés pour obtenir d'une part de l'eau pure et d'autre part la molécule hôte de nouveau adsorbée sur le support.

20. Procédé selon la revendication 19, dans lequel, lors de l'étape c1), on dissocie les clathrates hydrates en les faisant fondre.

21. Procédé selon la revendication 20, dans lequel la molécule hôte obtenue dans l'étape c1) est renvoyée dans l'étape a1).

## Patentansprüche

1. Verfahren zum Ausbilden, Auskristallisieren von Hydrat-Clathraten eines Gastmoleküls in einer Wasser umfassenden Flüssigkeit, **dadurch gekennzeichnet, dass** man die folgenden aufeinanderfolgenden Schritte ausführt :
- man kühlt die Flüssigkeit auf eine Temperatur ab, die niedriger als oder gleich der Kristallisationstemperatur der Hydrat-Clathrate ist,
- man beschickt die gekühlte Flüssigkeit mit Gastmolekülen, fähig Hydrat-Clathrate zu bilden, adsorbiert auf einem festen Träger mit großer spezifischer Oberfläche aus einem hydrophoben und apolaren Material, wobei die Gastmoleküle von dem festen Träger mit großer spezifischer Oberfläche aus einem hydrophoben und apolaren Material desorbiert werden und mit dem Wasser der Flüssigkeit reagieren, so dass man eine Hydrat-Clathrate und den festen Träger enthaltende Flüssigkeit erhält.

2. Verfahren nach Anspruch 1, bei dem der feste Träger eine spezifische Oberfläche von 100 bis 2000 m²/g hat.

3. Verfahren nach Anspruch 1 oder 2, das kontinuierlich durchgeführt wird.

4. Verfahren nach einem der vorhergehenden Ansprüche, bei dem der feste Träger sich in Form von Einzelteilchen wie zum Beispiel Kugeln, Fasern oder Röhren präsentiert.

5. Verfahren nach einem der vorhergehenden Ansprüche, bei dem der feste Träger sich in Form eines Faserngewebes oder eines Faservliesstoffes präsentiert.

6. Verfahren nach einem der vorhergehenden Ansprüche, bei dem der feste Träger aus einem Material ist, das ausgewählt wird unter den Materialien, die fähig sind, das Gastmolekül mit einer Adsorptionsenergie niedriger als die Kristallisationsenergie der Hydrat-Clathrate zu adsorbieren ; vorzugsweise ist der adsorbierende feste Träger aus einem Material, das ausgewählt wird unter der Aktivkohle, den Metalloxiden wie zum Beispiel den Aluminiumoxiden ; den Halbmetalloxiden wie zum Beispiel den Siliciumdioxiden, insbesondere den mesoporösen Siliciumdioxiden ; den Zeolithen ; und den organischen Polymeren.

7. Verfahren nach einem der vorhergehenden Ansprüche, bei dem das Gastmolekül ausgewählt wird unter den linearen oder verzweigten 1 bis 6 Kohlenstoffatome enthaltenden Kohlenwasserstoffen wie zum Beispiel dem Methan, dem Ethan, den Propanen, und den Butanen ; den halogenhaltigen Kohlenwasserstoffen; den 3 bis 10 Kohlenstoffatome enthaltenden cyclischen Kohlenwasserstoffen; dem CO₂; dem Sauerstoff; dem Stickstoff; dem H₂S ; den Edelgasen wie dem Argon, dem Krypton und dem Xenon ; dem Tetrahydrofuran ; dem Ethylenoxid ; dem Schwefelhexafluorid ; dem Tetra-n-butylammoniumbromid (TBAB); und dem N₂O.

8. Verfahren nach einem der vorhergehenden Ansprüche, bei dem das Gastmolekül unvermischbar mit Wasser oder unlösbar in Wasser ist.

9. Verfahren nach einem der vorhergehenden Ansprüche, bei dem das Gastmolekül ausgewählt wird unter den Gastmolekülen, die ermöglichen, Hydrat-Clathrate bei Atmosphärendruck und bei höheren Temperaturen als der der Kristallisation des Eises zu kristallisieren.

10. Verfahren nach einem der vorhergehenden Ansprüche, bei dem das Gastmolekül ausgewählt wird unter den Gastmolekülen, die ein Hydrat-Clathrat mit einer Dichte bilden, die niedriger als die Dichte der wässrigen Lösung ist, zum Beispiel niedriger als 1,3, vorzugsweise niedriger als 1,0.

11. Verfahren nach einem der vorhergehenden Ansprüche, bei dem das Gastmolekül das Cyclopentan oder das Cyclohexcan ist.

12. Verfahren nach einem der vorhergehenden Ansprüche, bei dem die Wasser umfassende Flüssigkeit Wasser und wenigstens eine Verunreinigung enthält.

13. Verfahren nach Anspruch 12, bei dem die Flüssigkeit eine wässrige Lösung ist.

14. Verfahren nach einem der Ansprüche 12 und 13, bei dem die Verunreinigung jedes Element, Molekül, Ion, oder ähnliches, von den Bestandteilen des reinen Wassers, nämlich H₂O, OH⁻, und H⁺, verschiedenes ist.

15. Verfahren nach Anspruch 14, bei dem die Verunreinigung ausgewählt wird unter den mineralischen Salzen wie zum Beispiel NaCl, den organischen Salzen, den wasserlöslichen organischen Verbindungen, und ihren Mischungen.

16. Verfahren nach einem der Ansprüche 12 bis 15, bei dem die Flüssigkeit ausgewählt wird unter dem Meerwasser ; den Brackwässern ; den Auslaugungen von Mülldeponien ; den Erdölförderungswässern ; den Wässern zur Gewinnung von Schiefergas durch die Technik der Hydraulischen Frakturierung ; den Flüssigkeiten der Nahrungsmittelindustrie wie zum Beispiel Fruchtsäfte oder Kaffee ; den Flüssigkeiten der phamazeutischen Industrie ; den Flüssigkeiten der chemischen Industrie ; den Bergbau-Abwässern, zum Beispiel die mit Sulfaten, Phosphaten oder Carbonaten belasteten Abfälle ; den Abwässern der metallurgischen Industrie ; den Abwässern der Nuklearindustrie ; den Konzentraten der Umkehrosmose ; den Entkalkungslösungen ; den Abwässern der Papierindustrie ; den salzhaltigen Grundwässern.

17. Verfahren nach einem der Ansprüche 12 bis 16, bei dem die Flüssigkeit eine Konzentration der Verunreinigung(en) von 1 mg/L bis 500 g/L, vorzugsweise 100 mg/L - 250 g/L, ist.

18. Verfahren nach einem der Ansprüche 12 bis 17, bei dem die Flüssigkeit ausgewählt wird unter den wässrigen Lösungen von NaCl, dessen NaCI-Konzentration höher als 150 g/L ist.

19. Verfahren zur Reinigung einer Wasser und wenigstens eine Verunreinigung enthaltenden Flüssigkeit, bei dem man die folgenden aufeinanderfolgenden Schritte ausführt :
a1) man bildet durch das Verfahren nach einem der Ansprüche 12 bis 18 in der Flüssigkeit Hydrat-Clathrate des Gastmoleküls;
b1) man trennt die Hydrat-Clathrate und den festen Träger von der Flüssigkeit;
c1) man dissoziert sondert die getrennten Hydrat-Clathrate, um einerseits reines Wasser und andrerseits das wieder auf dem Träger adsorbierte Gastmolekül zu erhalten.

20. Verfahren nach Anspruch 19, bei dem man in Schritt c1) die Hydrat-Clathrate dissoziert, indem man sie zum Schmelzen bringt.

21. Verfahren nach Anspruch 20, bei dem man das in Schritt c1) erhaltene Gastmolekül wieder in den Schritt a1) zurückschickt.

## Claims

1. Method for forming, crystallising, clathrates hydrates of a host molecule in a liquid comprising water, **characterised in that** the following successive steps are carried out:
- the liquid is cooled to a temperature less than or equal to the crystallisation temperature of the clathrates hydrates;
- host molecules capable of forming clathrates hydrates are introduced into the cooled liquid, adsorbed onto a solid support having a high specific surface area and made of an apolar and hydrophobic material, whereby the host molecules are desorbed from the solid support having a high specific surface area and made of an apolar and hydrophobic material and react with the water of the liquid to give a liquid containing clathrates hydrates and the solid support.

2. Method according to claim 1, wherein the solid support has a specific surface area from 100 to 2000m²/g.

3. Method according to claim 1 or 2 that is carried out continuously.

4. Method according to any one of the preceding claims, wherein the solid support is in the form of discrete particles, such as beads, fibres, or tubes.

5. Method according to any one of the preceding claims, wherein the solid support is in the form of a fabric of fibres or of a nonwoven fabric of fibres.

6. Method according to any one of the preceding claims, wherein the solid support is made of a material chosen from the materials capable of adsorbing the host molecule with an adsorption energy lower than the energy of crystallisation of the clathrates hydrates; preferably, the adsorbent solid support is made of a material chosen from activated carbon; the oxides of metals such as the aluminas; the oxides of metalloids such as the silicas, in particular the mesoporous silicas; the zeolites; and the organic polymers.

7. Method according to any one of the preceding claims, wherein the host molecule is chosen from the linear or branched hydrocarbons comprising from 1 to 6 carbon atoms such as methane, ethane, propanes, and butanes; the halogenated hydrocarbons; the cyclic hydrocarbons comprising 3 to 10 carbon atoms; CO₂; oxygen; nitrogen; H₂S; the rare gases such as argon, krypton and xenon; tetrahydrofuran; ethylene oxide; sulphur hexafluoride; tetra-n-butylammonium bromide (TBAB); and N₂O.

8. Method according to any one of the preceding claims, wherein the host molecule is immiscible with water, or insoluble in water.

9. Method according to any one of the preceding claims, wherein the host molecule is chosen from host molecules that allow crystallising of clathrates hydrates at atmospheric pressure and at temperatures greater than that of the crystallisation of ice.

10. Method according to any one of the preceding claims, wherein the host molecule is chosen from the molecules that form a clathrate hydrate having a specific gravity lower than the specific gravity of the aqueous solution, for example lower than 1.3, preferably lower than 1.0.

11. Method according to any one of the preceding claims, wherein the host molecule is cyclopentane or cyclohexane.

12. Method according to any one of the preceding claims, wherein the liquid comprising water comprises water and at least one impurity.

13. Method according to claim 12, wherein the liquid is an aqueous solution.

14. Method according to any one of claims 12 and 13, wherein the impurity is any element, molecule, ion, or other, different than the elements constituting pure water, namely H₂O, OH⁻, and H⁺.

15. Method according to claim 14, wherein the impurity is chosen from the mineral salts such as NaCl, the organic salts, the organic compounds soluble in water, and their mixtures.

16. Method according to any one of claims 12 to 15, wherein the liquid is chosen from seawater; brackish waters; public landfills leachates; waters from oil production; waters from extraction of shale gas by the hydraulic fracturing technique; liquids from the agri-food industry such as fruit juices or coffee; liquids from the pharmaceutical industry; liquids from the chemical industry; mining effluents, for example mining discharges loaded with sulphates, phosphates or carbonates; effluents from the metallurgical industry; effluents from the nuclear industry; reverse-osmosis concentrates; scaling solutions; effluents from the paper industry; saline aquifers.

17. Method according to any one of claims 12 to 16, wherein the liquid has a concentration of impurity or impurities from 1 mg/L to 500 g/L, preferably from 100 mg/L to 250 g/L.

18. Method according to any one of claims 12 to 17, wherein the liquid is chosen from the aqueous solutions of NaCl having a concentration of NaCl greater than 150 g/L.

19. Method for purifying a liquid comprising water and at least one impurity, wherein the following successive steps are carried out:
a1) clathrates hydrates of the host molecule are formed in the liquid by the method according to any one of claims 12 to 18;
b1) the clathrates hydrates and the solid support are separated from the liquid;
c1) the separated clathrates hydrates are dissociated in order to obtain, on the one hand, pure water and, on the other hand, the host molecule once again adsorbed onto the solid support.

20. Method according to claim 19, wherein during step c1), the clathrates hydrates are dissociated by melting them.

21. Method according to claim 20, wherein the host molecule adsorbed onto the solid support and obtained after step c1) is sent back to step a1).
